# EUROPÄISCHE PATENTSCHRIFT

(11) **EP 2 647 042 B1**
(45) Veröffentlichungstag und Bekanntmachung des Hinweises auf die Patenterteilung: **11.03.2015**
(21) Anmeldenummer: 11793751.6
(22) Anmeldetag: 05.12.2011
(51) Int. Cl.: G01L 9/00, G01R 31/27, G01L 27/00, G01R 31/28, B81C 99/00

(54) **VERFAHREN ZUR VERMESSUNG EINES MIKRO-ELEKTROMECHANISCHEN HALBLEITERBAUTEILS**
METHOD FOR MEASURING A MICROELECTROMECHANICAL SEMICONDUCTOR COMPONENT
PROCÉDÉ DE MESURE D'UN COMPOSANT SEMI-CONDUCTEUR MICRO-ÉLECTROMÉCANIQUE

(30) Priorität: 03.12.2010 EP 10193596
(43) Veröffentlichungstag der Anmeldung: 09.10.2013
(73) Patentinhaber: ELMOS Semiconductor AG, 44227 Dortmund (DE)
(72) Erfinder: BINKHOFF, Peter, 44227 Dortmund (DE)
(74) Vertreter: Von Kreisler Selting Werner - Partnerschaft von Patentanwälten und Rechtsanwälten mbB
(86) Internationale Anmeldenummer: PCT/EP2011/071762
(87) Internationale Veröffentlichungsnummer: WO 2012/072818

(56) Entgegenhaltungen:
- US-A1- 2007 080 695
- PATIL S K ET AL: "Characterization of MEMS piezoresistive pressure sensors using AFM", ULTRAMICROSCOPY, ELSEVIER, AMSTERDAM, NL, Bd. 110, Nr. 9, 1. August 2010 (2010-08-01), Seiten 1154-1160, XP027174554, ISSN: 0304-3991 [gefunden am 2010-04-24]

## Beschreibung

Die Erfindung betrifft ein Verfahren zur Vermessung eines mikro-elektromechanischen Halbleiterbauteils, das ein reversibel verformbares druckempfindliches Messelement und elektronische Schaltungselemente sowie Anschlussfelder zum Abgreifen von Messsignalen aufweist.

Bei mikro-elektromechanischen Halbleiterbauteilen handelt es sich um Kleinstbauteile aus Halbleitermaterial, die sowohl mechanische als auch elektrische Funktionen aufweisen. So weisen diese Halbleiterbauteile bewegbare bzw. verformbare Elemente auf, die beispielsweise der messtechnischen Erfassung physikalischer Größen dienen können. Eine Gruppe mikro-elektromechanischer Halbleiterbauteile betrifft beispielsweise Drucksensoren, die über ein reversibel verformbares druckempfindliches Messelement zumeist in Form einer Membran verfügen. Neben einem derartigen (z. B. Mess-)Element weisen die Halbleiterbauteile elektronische Schaltungselemente sowie gegebenenfalls Auswerteschaltungen und Anschlussfelder zum Abgreifen von Messsignalen auf. Im Falle eines Drucksensors umfassen die Schaltungselemente solche, die die mechanischen Spannungen beim Verformen der Messelemente detektieren. Beispielsweise handelt es sich bei diesen Schaltelementen um druckempfindliche Transistoren oder Widerstände, die in dem Messelement integriert sind und beispielsweise in einer Brückenschaltung angeordnet sind.

Mikro-elektromechanische Halbleiterbauteile werden wie integrierte Halbleiterschaltungen auf einem Halbfeitersubstrat-Wafer hergestellt. Diese Wafer werden in einem sogenannten Wafer-Prober einem Wafer-Test unterzogen; beim Test der mikro-elektromechanischen Halbleiterbauteile sind diese also noch nicht vereinzelt. Es ist bekannt, während des Wafer-Tests neben den elektrischen auch die mechanischen Funktionen der mikro-elektromechanischen Halbleiterbauteile zu testen. Im Falle von Drucksensoren wird hier beispielsweise ein Staudruckverfahren angewendet, bei dem das zu testende Halbleiterbauteil durch einen definierten Luftstrom angeblasen wird. Ferner ist es bekannt, über dem Wafer eine Druckkammer anzuordnen und den Wafer dann in dieser atmosphärischen Umgebung innerhalb der Wafer-Prober-Testanordnung zu testen. Schließlich kann man auch die Wafer-Prober-Anordnung vollständig in eine Druckkammer verbringen, um dann die Drucksensoren auf dem Wafer zu testen. In sämtlichen zuvor genannten Fällen bewirkt der von außen angelegte Druck eine Auslenkung des reversibel verformbaren Messelements, und zwar proportional zum angelegten Druck.

Aus Patil S K et al.: "Characterization of MEMS piezoresistive pressure sensors using AFM", ULTRAMICROSCOPY, ELSEVIER, AMSTERDAM, NL, Bd. 110, Nr. 9, 1. August 2010 (2010-08-01), Seiten 1154-1160, XP027174554, ISSN: 0304-3991, ist ein Testverfahren für MEMS-Drucksensoren bekannt, bei dem mittels eines Stößels auf das druckempfindliche Messelement mit einer vorgebbaren Kraft mechanisch eingewirkt wird und das dabei vom Drucksensor gelieferte Messsignal ausgewertet wird. Hierbei ist ein Kraftsensor für den Stößel erforderlich, was mit zusätzlichen Hardware-Kosten verbunden ist und eine Kalibration des Kraftsensors erfordert.

US-A-2007/0080695 beschreibt eine Testanordnung sowie ein Testverfahren für kapazitive MEMS-Sensoren mit einer bewegbaren (Kondensator-)Platte, die mechanisch bewegt wird.

Die bekannten Testverfahren für mikro-elektromechanische Halbleiterbauteile sind relativ aufwendig und erfordern eine im Vergleich zu integrierten Schaltungen nicht unbeträchtlich apparativ geänderte Wafer-Prober-Testanordnung. Außerdem unterliegen sie Einschränkungen bezüglich des Druckbereichs bzw. es müssen die Testaufbauten für verschiedene Dicken der druckempfindlichen Messelemente unterschiedlich ausgestaltet sein.

Von den Anwendern von Drucksensoren wird mitunter gefordert, dass diese Drucksensoren für einen bestimmten Arbeitsbereich ausgelegt und darüber hinaus in der Lage sein müssen, auch Maximaldrucken, die ein Vielfaches eines Nenndrucks betragen können, standhalten müssen.

Aufgabe der Erfindung ist es, ein Verfahren und eine Vorrichtung zur Vermessung eines mikro-elektromechanischen Halbleiterbauteils zu schaffen, die über einen vereinfachten apparativen Aufbau verfügen.

Zur Lösung dieser Aufgabe wird mit der Erfindung ein Verfahren zur Überprüfung eines Drucksensors mit einem reversibel verformbaren, insbesondere reversibel verbiegbaren Messelement, das ein Messsignal mit einer von dem Grad seiner Verformung abhängigen Größe liefert, dahingehend, ob der Drucksensor einem geforderten Maximaldruck standhält, der um einen vorgebbaren Faktor größer ist als ein Nenndruck, für den der Drucksensor ausgelegt ist, vorgeschlagen, wobei bei dem Verfahren
- ein zum zu überprüfenden Drucksensor baugleicher Referenzdrucksensor bereitgestellt wird, der ein reversibel verformbares, insbesondere reversibel verbiegbares Messelement aufweist, welches ein Messsignal mit einer von dem Grad seiner Verformung abhängigen Größe liefert (wobei insbesondere bis zu einem vorbestimmten Grad einer reversiblen Verformung des Messelements die Abhängigkeit der Größe des Messsignals von der reversiblen Verformung des Messelements als Weg/Druck-Kennlinie bekannt ist und wobei der für ein Zerbrechen des Messelements erforderliche kritische Druck (nämlich derjenige Druck, bei dem das Messelement, ohne dass es zerbrochen war, maximal verformt war) größer ist als der geforderte Maximaldruck, dem der zu überprüfende Drucksensor standhalten soll,)
- ein weggesteuert vorbewegbarer Auslenkstößel bereitgestellt wird, wobei der Auslenkstößel mit Ausnahme des Referenzdrucksensors oder eines zu überprüfenden Drucksensors frei von einem mit ihm in Wirkverbindung stehenden Sensor zur Ermittlung der zur Vorbewegung des Auslenkstößels jeweils erforderlichen Kraft ist,
- der Auslenkstößel in Kontakt mit dem Messelements des Referenzdrucksensors gebracht wird und anschließend unter reversibler Verformung des Messelements weggesteuert vorbewegt wird,
- das Messelement durch den weggesteuert vorbewegten Auslenkstößel in zunehmendem Maße verformt wird, bis das Messelement bricht,
- die von dem Messelement bei zunehmender Verformung desselben gelieferten Messsignale erfasst werden,
- der von dem Auslenkstößel vom Beginn der reversiblen Verformung des Messelements an bis zum Zerbrechen des Messelements zurückgelegte Weg ermittelt wird,
- die Größe des Messsignals bei maximaler reversibler Verformung des Messelements, ohne dass dieses zerbrochen war, als kritisches Messsignal ermittelt wird,
- anhand der bekannten Weg/Druck-Kennlinie des Referenzdrucksensors die Größe des dem kritischen Messsignal entsprechenden kritischen Drucks (nämlich derjenige Druck, bei dem das Messelement, ohne dass es zerbrochen war, maximal verformt war) oder die Größe eines diesen Druck repräsentierenden Parameters ermittelt wird,
- das Messelement mindestens eines zu überprüfenden Drucksensors mittels des weggesteuert vorbewegten Auslenkstößels bis zu einem vorgebbaren Grad reversibel verformt und dabei seine Weg/Druck-Kennlinie erstellt wird, und
- anhand eines Vergleichs der erstellten Weg/Druck-Kennlinie des zu überprüfenden Drucksensors mit der bekannten Weg/Druck-Kennlinie des Referenzdrucksensors erkannt wird, ob das Messelement des zu überprüfenden Drucksensors dem geforderten Maximaldruck standhält oder bei diesem zerbrechen würde bzw. bereits zerbrochen wäre (d. h. es wird überprüft, ob das Messelement des zu überprüfenden Drucksensors bei einem kritischen Druck in gleicher Größe wie bei dem Referenzdrucksensor oder einem anderen kritischen Druck zerbrechen würde und, wenn das letztere der Fall ist, ob der andere kritische Druck oberhalb des geforderten Maximaldrucks liegt).

Gemäß einer weiteren Variante der Erfindung wird mit dieser zur Lösung der obigen Aufgabe ein Verfahren zur Überprüfung eines Drucksensors mit einem reversibel verformbaren, insbesondere reversibel verbiegbaren Messelement, das ein Messsignal mit einer von dem Grad seiner Verformung abhängigen Größe liefert, dahingehend, ob der Drucksensor einem geforderten Maximaldruck standhält, der um einen vorgebbaren Faktor größer ist als ein Nenndruck, für den der Drucksensor ausgelegt ist, vorgeschlagen, wobei bei dem Verfahren
- ein zum zu überprüfenden Drucksensor baugleicher Referenzdrucksensor bereitgestellt wird, der ein reversibel verformbares, insbesondere reversibel verbiegbares Messelement aufweist, welches ein Messsignal mit einer von dem Grad seiner Verformung abhängigen Größe liefert (wobei insbesondere bis zu einem vorbestimmten Grad einer reversiblen Verformung des Messelements die Abhängigkeit der Größe des Messsignals von der reversiblen Verformung des Messelements als Weg/Druck-Kennlinie bekannt ist und wobei der für ein Zerbrechen des Messelements erforderliche kritische Druck (nämlich derjenige Druck, bei dem das Messelement, ohne dass es zerbrochen war, maximal verformt war) größer ist als der geforderte Maximaldruck, dem der zu überprüfende Drucksensor standhalten soll),
- ein weggesteuert vorbewegbarer Auslenkstößel bereitgestellt wird, wobei der Auslenkstößel mit Ausnahme des Referenzdrucksensors oder eines zu überprüfenden Drucksensors frei von einem mit ihm in Wirkverbindung stehenden Sensor zur Ermittlung der zur Vorbewegung des Auslenkstößels jeweils erforderlichen Kraft ist,
- der Auslenkstößel in Kontakt mit dem Messelements des Referenzdrucksensors gebracht wird und anschließend unter reversibler Verformung des Messelements weggesteuert vorbewegt wird,
- das Messelement durch den weggesteuert vorbewegten Auslenkstößel in zunehmendem Maße verformt wird, bis das Messelement bricht,
- die von dem Messelement bei zunehmender Verformung desselben gelieferten Messsignale erfasst werden,
- der von dem Auslenkstößel vom Beginn der reversiblen Verformung des Messelements an bis zum Zerbrechen des Messelements zurückgelegte Weg ermittelt wird,
- die Größe des Messsignals bei maximaler reversibler Verformung des Messelements, ohne dass dieses zerbrochen war, als kritisches Messsignal ermittelt wird,
- anhand der bekannten Weg/Druck-Kennlinie des Referenzdrucksensors die Größe des dem kritischen Messsignal entsprechenden kritischen Drucks (nämlich derjenige Druck, bei dem das Messelement, ohne dass es zerbrochen war, maximal verformt war) oder die Größe eines diesen Druck repräsentierenden Parameters ermittelt wird,
- anhand der Größe des vom Auslenkstößel vom Beginn der reversiblen Verformung des Messelements bis zu seiner maximalen reversiblen Verformung zurückgelegten Maximalweg und der Weg/Druck-Kennlinie des Referenzdrucksensors die Größe des Maximalwegs des Auslenkstößels ermittelt wird, bei dem das Messelement beim geforderten Maximaldruck verformt ist, und
- das Messelement mindestens eines zu überprüfenden Drucksensors mittels des weggesteuerten Auslenkstößels ausgelenkt wird,
- wobei der Auslenkstößel ab seiner Kontaktierung des Messelements um den Maximalweg vorbewegt wird und dadurch überprüft wird, ob das Messelement der dabei erfolgenden Auslenkung standhält.

Schließlich wird mit der Erfindung ferner ein Verfahren zur Ermittlung der Größe eines kritischen Drucks (nämlich derjenige Druck, bei dem das Messelement, ohne dass es zerbrochen war, maximal verformt war), dem ein Drucksensor mit einem Messelement, ohne dass dieses zerbricht, standhält, wobei das Messelement ein Messsignal mit einer bis zu einem vorbestimmten Grad an reversibler Verformung in Abhängigkeit von dieser gemäß einer bekannten Weg/Druck-Kennlinie variierenden Größe liefert und wobei die Ermittlung der Größe des kritischen Drucks (nämlich derjenige Druck, bei dem das Messelement, ohne dass es zerbrochen war, maximal verformt war) erfolgt, ohne dass der Drucksensor dem kritischen Druck (nämlich derjenige Druck, bei dem das Messelement, ohne dass es zerbrochen war, maximal verformt war) ausgesetzt wird, vorgeschlagen, wobei bei dem Verfahren
- ein weggesteuert vorbewegbarer Auslenkstößel bereitgestellt wird, wobei der Auslenkstößel mit Ausnahme des Referenzdrucksensors oder eines zu überprüfenden Drucksensors frei von einem mit ihm in Wirkverbindung stehenden Sensor zur Ermittlung der zur Vorbewegung des Auslenkstößels jeweils erforderlichen Kraft ist,
- der Auslenkstößel in Kontakt mit dem verformbaren Messelement gebracht und anschließend unter Verformung des Messelements weggesteuert vorbewegt wird,
- das Messelement durch Vorbewegung des Auslenkstößels verformt wird, bis es bricht,
- die von dem Messelement bei zunehmender Verformung desselben gelieferten Messsignale erfasst werden,
- der von dem Auslenkstößel vom Beginn der Verformung des Messelements an bis zu dessen Zerbrechen zurückgelegte Weg ermittelt wird,
- die Größe des Messsignals bei maximaler reversibler Verformung, ohne dass das Messelement zerbrochen war, als kritisches Messsignal ermittelt wird, und
- anhand der Weg/Druck-Kennlinie des Drucksensors die Größe des dem kritischen Messsignal entsprechenden kritischen Drucks (nämlich derjenige Druck, bei dem das Messelement, ohne dass es zerbrochen war, maximal verformt war) ermittelt wird.

Des Weiteren wird mit der Erfindung die Verwendung eines weggesteuert vorbewegbaren Auslenkstößels zur Überprüfung der Funktionalität eines reversibel verformbaren, insbesondere reversibel verbiegbaren Messelements eines Drucksensors durch Verformung des Messelements mittels des zunehmend vorbewegbaren Auslenkstößels, vorgeschlagen, wobei die Kraft, mit der der Auslenkstößel auf das Messelement einwirkt und/oder der dieser Kraft entsprechende Druck, der auf das Messelement einwirkt, anhand von von dem Messelement mit zunehmender Verformung gelieferten Messsignalen ermittelt wird.

Nach der Erfindung wird das bezüglich mechanischer Spannungen empfindliche Messelement, bei dem es sich z. B. um ein druckempfindliches Messelement handelt, unter mechanischer Einwirkung mittels eines schrittweise vorbewegbaren Stößels, bei dem es sich insbesondere um eine Nadel handelt, verformt. Nach einer bzw. nach jeder definierten schrittweisen Vorbewegung des Stößels werden die aktuell anstehenden Messsignale über die Anschlussfelder abgegriffen. Damit kann die Charakteristik des Messelements ermittelt und das Halbleiterbauteil insgesamt qualifiziert werden. Die reversible Verformbarkeit des Messelements kann darüber hinaus mit dem erfindungsgemäßen Verfahren bzw. der erfindungsgemäßen Vorrichtung, über die Geometrie des Messelements betrachtet, ortsaufgelöst durchgeführt werden, indem das Messelement in mehreren Testläufen an unterschiedlichen Stellen der mechanischen Einwirkung durch den Stößel ausgesetzt wird. Das Messelement kann z. B. ein an vier Seiten an einem Substrat angebundenes verformbares Element (Membran) sein oder aber 3-fach, 2-fach (Brücke) oder 1-fach (freitragender Balken) angebunden sein. Die Verformung kann z.B. mittels eines insbesondere piezoresistiven, für mechanische Spannungen empfindlichen Transistors oder Widerstands erfasst werden.

Anstelle einer schrittweisen Vorbewegung des Stößels kann dieser beispielsweise auch kontinuierlich bewegt werden, wobei dann während der Verformung des Messelements in vorgebbaren zeitlichen Abständen, nämlich nach jeweils definierten unterschiedlich starken Auslenkungen des Messelements, die Messsignale ausgewertet werden. Auch auf diese Weise ist die Charakteristik des mikro-elektromechanischen Halbleiterbauteils messbar und qualifizierbar. Ebenso lässt sich durch eine kontinuierliche Verformung des Messelements auch dessen Dynamik messtechnisch erfassen, wobei zu diesem Zweck die Geschwindigkeit, mit der der Stößel vorbewegt wird, veränderbar ist. Letzteres ist aber auch bei einer schrittweisen Vorbewegung des Stößels möglich.

Als Antrieb für die schrittweise Vorbewegung des Stößels eignet sich beispielsweise ein Piezo-Linear-Motor; grundsätzlich kann aber jeder Schrittmotor oder jeder andere Motor oder allgemein jedes elektromechanische oder auch auf andere physikalische Art arbeitende Stellglied eingesetzt werden, durch den sich reproduzierbare schrittweise Vorbewegungen realisieren lassen.

Wie bereits oben erwähnt, kann der Stößel als Nadel ausgebildet sein. Auch ein Wafer-Prober arbeitet mit (Abtast- bzw. Abgriff-)Nadeln, mit denen die Anschlussfelder einer Halbleiterschaltung abgegriffen werden. Das erfindungsgemäße Verfahren lässt sich damit in einen Wafer-Prober integrieren. Die das reversibel verformbare Messelement auslenkende Nadel besteht dabei beispielsweise aus Keramik, Glasfaser, Kunststoff, Wolfram oder einem anderen Material. Das das Messelement kontaktierende Ende des Stößels bzw. der Nadel sollte gerundet sein.

Nach dem erfindungsgemäßen Verfahren wird zunächst ein Referenzdrucksensor untersucht, der zum eigentlich zu überprüfenden Drucksensor baugleich ist. Bei dem Referenzdrucksensor kann es sich beispielsweise um einen Drucksensor der Vielzahl von auf einem Silizium-Wafer befindlichen Drucksensoren handeln. Der Referenzdrucksensor wird, wie oben erläutert, mit Hilfe des weggesteuert vorbewegbaren Auslenkstößels ausgelenkt, bis sein reversibel verformbares Messelement bricht. Der Grad der Verformung kurz vor dem Zerbrechen des Messelements kann ermittelt werden, und zwar anhand des bis zu diesem Zeitpunkt zurückgelegten Wegs des Auslenkstößels. Aus der an sich bekannten Weg/Druck-Kennlinie des Referenzdrucksensors, die zuvor ermittelt worden ist (wozu der Referenzdrucksensor ggf. kalibriert werden musste), kann dann die Größe des Drucks ermittelt werden, bei dem das Messelement noch nicht zerbrochen ist. Dieser Druck sollte größer als der geforderte Maximaldruck sein. Andernfalls ist der Referenzdrucksensor an sich untauglich, womit dann wohl auch die anderen Drucksensoren auf dem Wafer untauglich wären. Dieser Fall soll im Vorliegenden allerdings ausgeschlossen werden.

Nachdem der Referenzdrucksensor auf die oben beschriebene Art vermessen worden ist, wird nun ein zu überprüfender Drucksensor dem vorbewegbaren Auslenkstößel ausgesetzt, indem sein Messelement vom Auslenkstößel ausgelenkt wird. Anhand der Weg/Druck-Kennlinie (bzw. einer diese repräsentierenden Kennlinie) kann dann das (statische) Verhalten des Drucksensors ermittelt werden. Durch Vergleich der Weg/Druck-Kennlinie mit der Weg/Druck-Kennlinie des Referenzdrucksensors kann dann festgestellt werden, ob der gerade überprüfte Drucksensor dem Maximaldruck standhält, und zwar ohne dass das Messelement der zum Aufbringen dieses Maximaldrucks erforderlichen Verformung ausgesetzt worden ist. Alternativ kann selbstverständlich der Auslenkstößel soweit auf das Messelement des zu überprüfenden Drucksensors einwirken, wie es beim Referenzdrucksensor bei maximaler reversibler Verformung seines Messelements (d. h. ohne dass dieses zerbrochen war) der Fall war.

In vorteilhafter Weiterbildung der Erfindung ist vorgesehen, dass die Größe des dem kritischen Messsignal entsprechenden kritischen Drucks anhand der bekannten Weg/Druck-Kennlinie des Referenzdrucksensors durch Extrapolation derselben bis zur Größe des kritischen Messsignals ermittelt wird.

Ein wesentliches Merkmal des erfindungsgemäßen Verfahrens ist die Verwendung eines ausschließlich weggesteuert vorbewegbaren Auslenkstößels zur Aufbringung von Verformungskräften auf das reversibel verformbare Messelement eines Drucksensors. Die Kraft, mit der der Auslenkstößel gegen das Messelement drückt und dieses verformt, wird dabei von der Einheit, die den vorbewegbaren Auslenkstößel umfasst, nicht selbst gemessen; insoweit weist diese Einheit also keine Sensorik zur Kraft- bzw. Druckmessung auf. Vielmehr wird die Kraft bzw. der Druck, die bzw. der auf das Messelement einwirkt, durch das Messelement bzw. den zu überprüfenden Drucksensor selbst ermittelt. Demzufolge weist also der Auslenkstößel selbst keine Lastzellen oder dergleichen Kraftsensoren auf.

Mit der Erfindung ist es möglich, mikro-elektromechanische Halbleiterbauteile (beispielsweise Drucksensoren) bezüglich ihrer Linearität, ihrer Empfindlichkeit, ihrer Temperaturabhängigkeit, ihrer Reversibilität, bezüglich ihrer Hysterese und/oder daraufhin zu untersuchen, ob bei diesen Halbleiterbauteilen überhaupt ein Messelement vorhanden ist und ob dieses Messelement mechanisch korrekt an den Rest des Halbleiterbauteils angebunden ist. Allgemein lässt sich also mit der Erfindung die Charakteristik eines mikro-elektromechanischen Halbleiterbauteils ermitteln und das Halbleiterbauteil selbst mechanisch vermessen. Entscheidend für die Erfindung ist, dass nicht die Kraft, mit der das Messelement durch den Stößel verformt wird, sondern der Weg, um den das Messelement durch den Stößel ausgelenkt und damit verformt wird, vorgegebenen wird und damit die Weg/Kraft- bzw. durch Umrechnung die Weg/Druck-Kennlinie des MEMS-Sensors vermessen und zu Zwecken der Qualifizierung des Bauteils gewählt wird.

Wie bereits oben erwähnt, kann es sich bei dem mikro-elektromechanischen Halbleiterbauteil um einen Drucksensor handeln. Ein nach der Erfindung zu vermessendes mikro-elektromechanisches Halbleiterbauteil kann aber auch als Beschleunigungssensor oder Viskositätssensor eingesetzt werden. Grundsätzlich kann mit der Erfindung jedwedes mikro-elektromechanische Halbleiterbauteil in jeder denkbaren Applikation getestet werden.

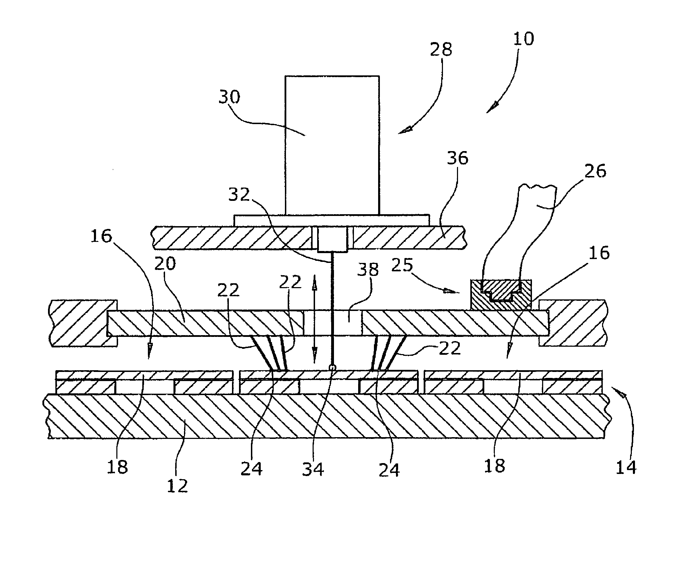

Die Erfindung wird nachfolgend anhand der Zeichnung näher erläutert.

In der Zeichnung ist schematisch der Testaufbau für einen Wafer-Prober 10 gezeigt, der einen Träger 12 für einen beispielsweise Silizium-Wafer 14 aufweist, in dem eine Vielzahl von mikro-elektromechanischen Halbleiterbauteil-Drucksensoren 16 ausgebildet sind. Jeder Drucksensor 16 weist dabei beispielsweise eine Membran 18 als reversibel verformbares, für mechanische Spannungen empfindliches, in diesem Fall z. B. druckempfindliches Messelement auf. Der Wafer-Prober 10 verfügt darüber hinaus über einen Träger 20 mit Testnadeln 22 zum Kontaktieren von Anschlussfeldern 24 der Drucksensoren 16. Darüber hinaus kann dieser Träger 20 beispielsweise elektronische Bauteile oder Schaltungen und einen Anschluss 25 für eine zu einer Testsignalauswerteschaltung führende Verkabelung 26 aufweisen.

Erfindungsgemäß wird nun ein derartiger Wafer-Prober 10 modifiziert, indem ein Stellglied 28 in Form beispielsweise eines Piezo-Linear-Motors 30 zur schrittweisen oder kontinuierlichen Vor- und Zurückbewegung eines der mechanischen Auslenkung der Drucksensor-Membranen 18 dienenden nadelförmigen Auslenkstößels 32 vorgesehen wird. Der nadelförmige Stößel 32 weist eine gerundete Spitze 34 auf, die beispielsweise als Mikrokugel ausgebildet sein kann. Zur Halterung des Stellgliedes 28 dient ein weiterer Träger 36, der oberhalb des Trägers 20 für die Nadeln 22 angeordnet sein kann. Der nadelförmige Auslenkstößel 32 erstreckt sich dann durch eine Öffnung 38 dieses Trägers 20 hindurch, ist also somit im Wesentlichen zentrisch zu den (elektrischen) Nadeln 22 angeordnet.

Überraschenderweise hat sich gezeigt, dass trotz der mechanischen Einwirkung auf die Membranen 18 durch Kontaktierung derselben mittels des nadelförmigen Auslenkstößels 32 keinerlei die Funktionalität der Membranen 18 beeinträchtigenden Beschädigungen an den Drucksensoren 16 durch den erfindungsgemäßen Test auftreten. Die Erfindung hat unter anderem den weiteren Vorteil, dass der gleiche Testaufbau für verschiedene Membrandicken verwendet werden kann, so dass insoweit keinerlei Einschränkungen für den Testdruckbereich gegeben sind. Die bei den unterschiedlich starken mechanischen Auslenkungen der Membranen 18 ermittelten Messwerte können mit einem entsprechenden Luftdruck korreliert werden. Damit kann insgesamt das Halbleiterbauteil qualifiziert werden. Beim erfindungsgemäßen mechanischen Test des verformbaren Elements kann dieses den gleichen Verformungen wie beim späteren Einsatz ausgesetzt werden. Insbesondere lassen sich somit beim Testen die gleichen Bedingungen wie bei der bestimmungsgemäßen Verwendung des Bauteils simulieren. Dies ist bei den bisher bekannten Testverfahren kaum möglich, da sich z. B. Drücke von mehreren 10 bis 100 bar beim Testen nicht bzw. nur mit extremem Aufwand realisieren lassen.

Der zuvor beschriebene Messaufbau lässt sich insbesondere auch zur Überprüfung von Drucksensoren einsetzen, die einem geforderten Berstdruck standhalten müssen. Bei diesem Druck, der ein Vielfaches des Nenndrucks betragen kann, dürfen die Sensoren noch nicht bersten. Durch den weggesteuert vorbewegbaren Auslenkstößel kann nun jeder Drucksensor auf seine Fähigkeit hin untersucht werden, dem Berstdruck standzuhalten. Hierzu wird zunächst ein Referenzdrucksensor mit Hilfe des Auslenkstößels untersucht, indem der Auslenkstößel das Messelement des Referenzdrucksensors bis zu dessen Zerbrechen verformt. Der (ab Beginn der Verformung) bis dahin zurückgelegte Weg des Auslenkstößels ist bekannt. In der Folge werden nun die Messelemente der zu untersuchenden Drucksensoren mit Hilfe des Auslenkstößels soweit verformt, wie es dem standzuhaltenden Berstdruck entspricht. Damit kann während des Testens auf dem Wafer bereits überprüft werden, ob die Drucksensoren dem Berstdrucktest standhalten oder nicht.

Alternativ zu der Auslenkung bis zum geforderten Ausmaß durch den Auslenkstößel können die Messelemente auch lediglich in einem geringeren Ausmaß ausgelenkt werden, um dann anhand der an sich bekannten Weg/Druck-Kennlinie, insbesondere durch Extrapolation, feststellen zu können, ob der gerade untersuchte Drucksensor dem geforderten Maximaldruck (Berstdruck) standhält.

Die Erfindung wurde vorstehend anhand eines Drucksensors beschrieben, der als mikro-elektromechanisches Halbleiterbauteil ausgeführt ist. Es sei an dieser Stelle darauf hingewiesen, dass die Erfindung für die Vermessung der verschiedensten mikro-elektromechanischen Halbleiterbauteile eingesetzt werden kann, die über reversibel verformbare und insbesondere reversibel verbiegbare, bezüglich mechanischer Spannungen empfindliche Messelemente mit elektronischen Schaltungselementen sowie Anschlussfeldern zum Abgreifen von Messsignalen eingesetzt werden können. Die Erfindung ist also mithin nicht auf Drucksensoren beschränkt.

## Patentansprüche

1. Verfahren zur Überprüfung eines Drucksensors mit einem reversibel verformbaren, insbesondere reversibel verbiegbaren Messelement (18), das ein Messsignal mit einer von dem Grad seiner Verformung abhängigen Größe liefert, dahingehend, ob der Drucksensor einem geforderten Maximaldruck standhält, der um einen vorgebbaren Faktor größer ist als ein Nenndruck, für den der Drucksensor ausgelegt ist, wobei bei dem Verfahren
- ein zum zu überprüfenden Drucksensor baugleicher Referenzdrucksensor bereitgestellt wird, der ein reversibel verformbares, insbesondere reversibel verbiegbares Messelement (18) aufweist, welches ein Messsignal mit einer von dem Grad seiner Verformung abhängigen Größe liefert,
- ein weggesteuert vorbewegbarer Auslenkstößel (32) bereitgestellt wird, wobei der Auslenkstößel (32) mit Ausnahme des Referenzdrucksensors oder eines zu überprüfenden Drucksensors frei von einem mit ihm in Wirkverbindung stehenden Sensor zur Ermittlung der zur Vorbewegung des Auslenkstößels (32) jeweils erforderlichen Kraft ist,
- der Auslenkstößel (32) in Kontakt mit dem Messelement (18) des Referenzdrucksensors gebracht wird und anschließend unter reversibler Verformung des Messelements (18) weggesteuert vorbewegt wird,
- das Messelement (18) durch den weggesteuert vorbewegten Auslenkstößel (32) in zunehmendem Maße verformt wird, bis das Messelement (18) bricht,
- die von dem Messelement (18) bei zunehmender Verformung desselben gelieferten Messsignale erfasst werden,
- der von dem Auslenkstößel (32) vom Beginn der reversiblen Verformung des Messelements (18) an bis zum Zerbrechen des Messelements (18) zurückgelegte Weg ermittelt wird,
- die Größe des Messsignals bei maximaler reversibler Verformung des Messelements (18), ohne dass dieses zerbrochen war, als kritisches Messsignal ermittelt wird,
- anhand der bekannten Weg/Druck-Kennlinie des Referenzdrucksensors die Größe des dem kritischen Messsignal entsprechenden kritischen Drucks oder die Größe eines diesen Druck repräsentierenden Parameters ermittelt wird,
- das Messelement (18) mindestens eines zu überprüfenden Drucksensors mittels des weggesteuert vorbewegten Auslenkstößels (32) bis zu einem vorgebbaren Grad reversibel verformt und dabei seine Weg/Druck-Kennlinie erstellt wird, und
- anhand eines Vergleichs der erstellten Weg/Druck-Kennlinie des zu überprüfenden Drucksensors mit der bekannten Weg/Druck-Kennlinie des Referenzdrucksensors erkannt wird, ob das Messelement (18) des zu überprüfenden Drucksensors dem geforderten Maximaldruck standhält oder bei diesem zerbrechen würde bzw. bereits zerbrochen wäre.

2. Verfahren zur Überprüfung eines Drucksensors mit einem reversibel verformbaren, insbesondere reversibel verbiegbaren Messelement (18), das ein Messsignal mit einer von dem Grad seiner Verformung abhängigen Größe liefert, dahingehend, ob der Drucksensor einem geforderten Maximaldruck standhält, der um einen vorgebbaren Faktor größer ist als ein Nenndruck, für den der Drucksensor ausgelegt ist, wobei bei dem Verfahren
- ein zum zu überprüfenden Drucksensor baugleicher Referenzdrucksensor bereitgestellt wird, der ein reversibel verformbares, insbesondere reversibel verbiegbares Messelement (18) aufweist, welches ein Messsignal mit einer von dem Grad seiner Verformung abhängigen Größe liefert,
- ein weggesteuert vorbewegbarer Auslenkstößel (32) bereitgestellt wird, wobei der Auslenkstößel (32) mit Ausnahme des Referenzdrucksensors oder eines zu überprüfenden Drucksensors frei von einem mit ihm in Wirkverbindung stehenden Sensor zur Ermittlung der zur Vorbewegung des Auslenkstößels (32) jeweils erforderlichen Kraft ist,
- der Auslenkstößel (32) in Kontakt mit dem Messelement (18) des Referenzdrucksensors gebracht wird und anschließend unter reversibler Verformung des Messelements (18) weggesteuert vorbewegt wird,
- das Messelement (18) durch den weggesteuert vorbewegten Auslenkstößel (32) in zunehmendem Maße verformt wird, bis das Messelement (18) bricht,
- die von dem Messelement (18) bei zunehmender Verformung desselben gelieferten Messsignale erfasst werden,
- der von dem Auslenkstößel (32) vom Beginn der reversiblen Verformung des Messelements (18) an bis zum Zerbrechen des Messelements (18) zurückgelegte Weg ermittelt wird,
- die Größe des Messsignals bei maximaler reversibler Verformung des Messelements (18), ohne dass dieses zerbrochen war, als kritisches Messsignal ermittelt wird,
- anhand der bekannten Weg/Druck-Kennlinie des Referenzdrucksensors die Größe des dem kritischen Messsignal entsprechenden kritischen Drucks oder die Größe eines diesen Druck repräsentierenden Parameters ermittelt wird,
- anhand der Größe des vom Auslenkstößel (32) vom Beginn der reversiblen Verformung des Messelements (18) bis zu seiner maximalen reversiblen Verformung zurückgelegten Maximalweg und der Weg/Druck-Kennlinie des Referenzdrucksensors die Größe des Maximalwegs des Auslenkstößels (32) ermittelt wird, bei dem das Messelement (18) beim geforderten Maximaldruck verformt ist, und
- das Messelement (18) mindestens eines zu überprüfenden Drucksensors mittels des weggesteuerten Auslenkstößels (32) ausgelenkt wird,
- wobei der Auslenkstößel (32) ab seiner Kontaktierung des Messelements (18) um den Maximalweg vorbewegt wird und dadurch überprüft wird, ob das Messelement (18) der dabei erfolgenden Auslenkung standhält.

3. Verfahren nach Anspruch 1 oder 2, **dadurch gekennzeichnet, dass** die Größe des dem kritischen Messsignal entsprechenden kritischen Drucks anhand der bekannten Weg/Druck-Kennlinie des Referenzdrucksensors durch Extrapolation derselben bis zur Größe des kritischen Messsignals ermittelt wird.

4. Verfahren zur Ermittlung der Größe eines kritischen Drucks, dem ein Drucksensor mit einem Messelement (18), ohne dass dieses zerbricht, standhält, wobei das Messelement (18) ein Messsignal mit einer bis zu einem vorbestimmten Grad an reversibler Verformung in Abhängigkeit von dieser gemäß einer bekannten Weg/Druck-Kennlinie variierenden Größe liefert und wobei die Ermittlung der Größe des kritischen Drucks erfolgt, ohne dass der Drucksensor dem kritischen Druck ausgesetzt wird, wobei bei dem Verfahren
- ein weggesteuert vorbewegbarer Auslenkstößel (32) bereitgestellt wird, wobei der Auslenkstößel (32) mit Ausnahme eines Referenzdrucksensors oder eines zu überprüfenden Drucksensors frei von einem mit ihm in Wirkverbindung stehenden Sensor zur Ermittlung der zur Vorbewegung des Auslenkstößels (32) jeweils erforderlichen Kraft ist,
- der Auslenkstößel (32) in Kontakt mit dem verformbaren Messelement (18) gebracht und anschließend unter Verformung des Messelements (18) weggesteuert vorbewegt wird,
- das Messelement (18) durch Vorbewegung des Auslenkstößels (32) verformt wird, bis es bricht,
- die von dem Messelement (18) bei zunehmender Verformung desselben gelieferten Messsignale erfasst werden,
- der von dem Auslenkstößel (32) vom Beginn der Verformung des Messelements (18) an bis zu dessen Zerbrechen zurückgelegte Weg ermittelt wird,
- die Größe des Messsignals bei maximaler reversibler Verformung, ohne dass das Messelement (18) zerbrochen war, als kritisches Messsignal ermittelt wird, und
- anhand der Weg/Druck-Kennlinie des Drucksensors die Größe des dem kritischen Messsignal entsprechenden kritischen Drucks ermittelt wird.

5. Verfahren nach Anspruch 4, **dadurch gekennzeichnet, dass** die Größe des dem kritischen Messsignal entsprechenden kritischen Drucks anhand der bekannten Weg/Druck-Kennlinie des Referenzdrucksensors durch Extrapolation derselben bis zur Größe des kritischen Messsignals ermittel wird.

6. Verfahren nach einem der Ansprüche 1 bis 5, **dadurch gekennzeichnet, dass** das statische Verhalten des Drucksensors überprüft wird.

7. Verwendung eines weggesteuert vorbewegbaren Auslenkstößels (32) zur Überprüfung der Funktionalität eines reversibel verformbaren, insbesondere reversibel verbiegbaren Messelements (18) eines Drucksensors durch Verformung des Messelements (18) mittels des zunehmend vorbewegbaren Auslenkstößels (32), bis das Messelement (18) bricht, wobei die Kraft, mit der der Auslenkstößel (32) auf das Messelement (18) einwirkt und/oder der dieser Kraft entsprechende Druck, der auf das Messelement (18) einwirkt, anhand von von dem Messelement (18) mit zunehmender Verformung gelieferten Messsignalen ermittelt wird.

8. Verwendung nach Anspruch 7 zur Überprüfung des statischen Verhaltens des Drucksensors.

## Claims

1. A method for checking a pressure sensor having a reversibly deformable, in particular reversibly bendable measuring element (18) which supplies a measurement signal having a value depending on the degree of deformation of said measuring element, to the effect of whether said pressure sensor withstands a required maximum pressure which is larger by a predeterminable factor than a nominal pressure for which said pressure sensor is designed, wherein in the method
- a reference pressure sensor is provided which is structurally identical to said pressure sensor to be checked and which comprises a reversibly deformable, in particular reversibly bendable measuring element (18) which supplies a measurement signal having a value depending on the degree of deformation of said measuring element,
- a deflection plunger (32) that can be advanced in a distance-controlled manner is provided, wherein said deflection plunger (32) with the exception of said reference pressure sensor or a pressure sensor to be checked is free of a sensor operatively connected thereto for determining the force respectively required for advancing said deflection plunger (32),
- said deflection plunger (32) is brought into contact with said measuring element (18) of said reference pressure sensor and is subsequently advanced in a distance-controlled manner with reversible deformation of said measuring element (18),
- said measuring element (18) is increasingly deformed by said deflection plunger (32) advanced in a distance-controlled manner until said measuring element (18) breaks,
- the measurement signals supplied by said measuring element (18) during increasing deformation thereof are detected,
- the distance covered by said deflection plunger (32) from the beginning of the reversible deformation of said measuring element (18) up to breakage of said measuring element (18) is determined,
- the value of the measurement signal upon maximum reversible deformation of said measuring element (18), without the latter having been broken, is determined as a critical measurement signal,
- the value of the critical pressure corresponding to the critical measurement signal or the value of a parameter representing said pressure is determined on the basis of the known distance/pressure characteristic curve of said reference pressure sensor,
- said measuring element (18) of at least one pressure sensor to be checked is reversibly deformed up to a predeterminable degree by means of said deflection plunger (32) advanced in a distance-controlled manner, and its distance/pressure characteristic curve is created, and
- a comparison of the created distance/pressure characteristic curve of said pressure sensor to be checked with the known pressure/distance characteristic curve of said reference pressure sensor is used as a basis for identifying whether said measuring element (18) of said pressure sensor to be checked withstands the required maximum pressure or would break or would already have been broken at said pressure.

2. A method for checking a pressure sensor having a reversibly deformable, in particular reversibly bendable measuring element (18) which supplies a measurement signal having a value depending on the degree of deformation of said measuring element, to the effect of whether said pressure sensor withstands a required maximum pressure which is larger by a predeterminable factor than a nominal pressure for which said pressure sensor is designed, wherein in the method
- a reference pressure sensor is provided which is structurally identical to said pressure sensor to be checked and which comprises a reversibly deformable, in particular reversibly bendable measuring element (18) which supplies a measurement signal having a value depending on the degree of deformation of said measuring element,
- a deflection plunger (32) that can be advanced in a distance-controlled manner is provided, wherein said deflection plunger (32) with the exception of said reference pressure sensor or a pressure sensor to be checked is free of a sensor operatively connected thereto for determining the force respectively required for advancing said deflection plunger (32),
- said deflection plunger (32) is brought into contact with said measuring element (18) of said reference pressure sensor and is subsequently advanced in a distance-controlled manner with reversible deformation of said measuring element (18),
- said measuring element (18) is increasingly deformed by said deflection plunger (32) advanced in a distance-controlled manner until said measuring element (18) breaks,
- the measurement signals supplied by said measuring element (18) during increasing deformation thereof are detected,
- the distance covered by said deflection plunger (32) from the beginning of the reversible deformation of said measuring element (18) up to breakage of said measuring element (18) is determined,
- the value of the measurement signal upon maximum reversible deformation of said measuring element (18), without the latter having been broken, is determined as a critical measurement signal,
- the value of the critical pressure corresponding to the critical measurement signal or the value of a parameter representing said pressure is determined on the basis of the known distance/pressure characteristic curve of said reference pressure sensor,
- the value of the maximum distance of said deflection plunger (32), at which said measuring element (18) is deformed at the required maximum pressure, is determined on the basis of the value of the maximum distance covered by said deflection plunger (32) from the beginning of the reversible deformation of said measuring element (18) up to its maximum reversible deformation and the distance/pressure characteristic curve of the reference pressure sensor, and
- said measuring element (18) of at least one pressure sensor to be checked is deflected by means of said distance-controlled deflection plunger (32),
- wherein said deflection plunger (32) is advanced by the maximum distance as from the place of its contacting said measuring element (18) and it is thus checked whether said measuring element (18) withstands the resultant deflection.

3. The method according to claim 1 or 2, **characterized in that** the value of the critical pressure corresponding to the critical measurement signal is determined on the basis of the known distance/pressure characteristic curve of the reference pressure sensor by extrapolation thereof up to the value of the critical measurement signal.

4. A method for determining the value of a critical pressure which a pressure sensor having a measuring element (18) withstands without breakage of said measuring element, wherein said measuring element (18) supplies a measurement signal with a value varying up to a predetermined degree of reversible deformation depending on the latter in accordance with a known distance/pressure characteristic curve, and wherein the determination of the value of the critical pressure is carried out without the pressure sensor being subjected to the critical pressure, wherein in the method
- a deflection plunger (32) that can be advanced in a distance-controlled manner is provided, wherein said deflection plunger (32) with the exception of the reference pressure sensor or a pressure sensor to be checked is free of a sensor operatively connected thereto for determining the force respectively required for advancing said deflection plunger (32),
- said deflection plunger (32) is brought into contact with said deformable measuring element (18) and is subsequently advanced in a distance-controlled manner with reversible deformation of said measuring element (18),
- said measuring element (18) is deformed by said deflection plunger (32) being advanced until the measuring element breaks,
- the measurement signals supplied by said measuring element (18) during increasing deformation thereof are detected,
- the distance covered by said deflection plunger (32) from the beginning of the deformation of said measuring element (18) up to breakage of the measuring element is determined,
- the value of the measurement signal upon maximum reversible deformation, without said measuring element (18) having been broken, is determined as a critical measurement signal, and
- the value of the critical pressure corresponding to the critical measurement signal is determined on the basis of the known distance/pressure characteristic curve of said pressure sensor.

5. The method according to claim 4, **characterized in that** the value of the critical pressure corresponding to the critical measurement signal is determined on the basis of the known distance/pressure characteristic curve of the reference pressure sensor by extrapolation thereof up to the value of the critical measurement signal.

6. The method according to any one of claims 1 to 5, **characterized in that** the static behavior of the pressure sensor is checked.

7. A use of a deflection plunger (32), which can be advanced in a distance-controlled manner, for checking the functionality of a reversibly deformable, in particular reversibly bendable measuring element (18) of a pressure sensor by deforming said measuring element (18) by means of said deflection plunger (32) which can be progressively advanced until breakage of the measurement element (18), wherein the force at which said deflection plunger (32) acts upon said measuring element (18) and/or the pressure corresponding to said force which acts upon said measuring element (18) is determined on the basis of measurement signals supplied by said measuring element (18) during increasing deformation thereof.

8. The use according to claim 7 for checking the static behavior of the pressure sensor.

## Revendications

1. Procédé pour vérifier un capteur de pression comprenant un élément de mesure (18) pouvant se déformer de façon réversible, en particulier fléchir de façon réversible, qui émet un signal de mesure ayant une valeur qui dépend du degré de sa déformation, avec pour but de vérifier si le capteur de pression résiste à une pression maximale exigée qui est supérieure d'un facteur pouvant être prédéterminé à une pression nominale pour laquelle le capteur de pression est conçu, et dans lequel :
- on met à disposition un capteur de pression de référence de même construction que le capteur de pression à vérifier, présentant un élément de mesure (18) pouvant se déformer de façon réversible, en particulier fléchir de façon réversible, qui émet un signal de mesure ayant une valeur qui dépend du degré de sa déformation,
- on met à disposition une tige de commande de déviation (32) que l'on peut déplacer en course commandée, la tige de commande de déviation (32), à l'exception du capteur de pression de référence ou d'un capteur de pression à vérifier, étant libérée d'un capteur mis en liaison effective avec lui pour déterminer la force nécessaire pour déplacer la tige de commande de déviation (32),
- on met la tige de commande de déviation (32) en contact avec l'élément de mesure (18) du capteur de pression de référence, puis on le déplace en course commandée avec déformation réversible de l'élément de mesure (18),
- on déforme l'élément de mesure (18) de façon croissante au moyen de la tige de commande de déviation (32) déplacée en course commandée jusqu'à ce que l'élément de mesure (18) se brise,
- on enregistre les signaux de mesure émis par l'élément de mesure (18) lors de la déformation croissante de cet élément,
- on détermine la course parcourue par la tige de commande de déviation (32) du début de la déformation réversible de l'élément de mesure (18) jusqu'à la rupture de l'élément de mesure (18),
- on détermine comme signal de mesure critique la valeur du signal de mesure au point de déformation réversible maximum atteint par l'élément de mesure (18) sans que cet élément se brise,
- sur la base de la courbe caractéristique course/pression connue du capteur de pression de référence, on détermine la valeur de la pression critique qui correspond au signal de mesure critique, ou la valeur d'un paramètre représentatif de cette pression,
- au moyen de la tige de commande de déviation (32) déplacée en course commandée, on déforme l'élément de mesure (18) d'au moins un capteur de pression à vérifier de façon réversible jusqu'à un degré pouvant être prédéterminé et on établit à cet effet une courbe caractéristique course/pression, et
- sur la base d'une comparaison de la courbe caractéristique course/pression du capteur de pression à vérifier avec la courbe caractéristique course/pression connue du capteur de pression de référence, on identifie si l'élément de mesure (18) du capteur de pression à vérifier résiste à la pression maximale exigée ou s'il se brise ou est déjà brisé à cette pression.

2. Procédé pour vérifier un capteur de pression comprenant un élément de mesure (18) pouvant se déformer de façon réversible, en particulier fléchir de façon réversible, qui émet un signal de mesure ayant une valeur qui dépend du degré de sa déformation, avec pour but de vérifier si le capteur de pression résiste à une pression maximale exigée qui est supérieure d'un facteur pouvant être prédéterminé à une pression nominale pour laquelle le capteur de pression est conçu, et dans lequel :
- on met à disposition un capteur de pression de référence de même construction que le capteur de pression à vérifier, présentant un élément de mesure (18) pouvant se déformer de façon réversible, en particulier fléchir de façon réversible, qui émet un signal de mesure ayant une valeur qui dépend du degré de sa déformation,
- on met à disposition une tige de commande de déviation (32) que l'on peut déplacer en course commandée, la tige de commande de déviation (32), à l'exception du capteur de pression de référence ou d'un capteur de pression à vérifier, étant libérée d'un capteur mis en liaison effective avec lui pour déterminer la force nécessaire pour déplacer la tige de commande de déviation (32),
- on met la tige de commande de déviation (32) en contact avec l'élément de mesure (18) du capteur de pression de référence, puis on le déplace en course commandée avec déformation réversible de l'élément de mesure (18),
- on déforme l'élément de mesure (18) de façon croissante au moyen de la tige de commande de déviation (32) déplacée en course commandée jusqu'à ce que l'élément de mesure (18) se brise,
- on enregistre les signaux de mesure émis par l'élément de mesure (18) lors de la déformation croissante de cet élément,
- on détermine la course parcourue par la tige de commande de déviation (32) du début de la déformation réversible de l'élément de mesure (18) jusqu'à la rupture de l'élément de mesure (18),
- on détermine comme signal de mesure critique la valeur du signal de mesure au point de déformation réversible maximum atteint par l'élément de mesure (18) sans que cet élément se brise,
- sur la base de la courbe caractéristique course/pression connue du capteur de pression de référence, on détermine la valeur de la pression critique qui correspond au signal de mesure critique, ou la valeur d'un paramètre représentatif de cette pression,
- sur la base de la valeur de la course maximum parcourue par la tige de commande de déviation (32) du début de la déformation réversible de l'élément de mesure (18) jusqu'à sa déformation réversible maximum, et de la courbe caractéristique course/pression du capteur de pression de référence, on détermine la valeur de la course maximale de la tige de commande de déviation (32), à laquelle l'élément de mesure (18) est déformé par la pression maximale exigée, et
- on fait dévier l'élément de mesure (18) d'au moins un capteur de pression à vérifier au moyen de la tige de commande de déviation en course commandée (32),
- la tige de commande de déviation (32) étant alors déplacée de la course maximale à partir de sa mise en contact avec l'élément de mesure (18) et on vérifie par ce moyen si l'élément de mesure (18) résiste à la déviation qui est produite à cet effet.

3. Procédé selon la revendication 1 ou 2, **caractérisé en ce qu'**on détermine la valeur de la pression critique correspondant au signal de mesure critique sur la base de la courbe caractéristique course/pression connue du capteur de pression de référence, par extrapolation de cette courbe jusqu'à la valeur du signal de mesure critique.

4. Procédé de détermination de la valeur d'une pression critique à laquelle un capteur de pression comprenant un élément de mesure (18) résiste sans que cet élément se brise, l'élément de mesure (18) émettant un signal de mesure qui présente une valeur qui varie selon une courbe caractéristique course/pression connue jusqu'à un degré prédéterminé de déformation réversible en fonction de cette valeur, la détermination de la valeur de la pression critique s'effectuant sans que le capteur de pression soit exposé à la pression critique, dans lequel procédé
- on met à disposition une tige de commande de déviation (32) que l'on peut déplacer en course commandée, la tige de commande de déviation (32), à l'exception du capteur de pression de référence ou d'un capteur de pression à vérifier, étant libérée d'un capteur mis en liaison effective avec lui pour déterminer la force nécessaire pour déplacer la tige de commande de déviation (32),
- on met la tige de commande de déviation (32) en contact avec l'élément de mesure (18) déformable puis on la déplace en course commandée avec déformation de l'élément de mesure (18),
- on déforme l'élément de mesure (18) par déplacement de la tige de commande de déviation (32) jusqu'à ce qu'il se brise,
- on capte les signaux de mesure émis par l'élément de mesure (18) lors de la déformation croissante de cet élément,
- on détermine la course parcourue par la tige de commande de déviation (32) du début de la déformation de l'élément de mesure (18) jusqu'à sa rupture,
- on détermine comme signal de mesure critique la valeur du signal de mesure au point de déformation réversible maximum atteint sans que l'élément soit brisé, et
- sur la base de la courbe caractéristique course/pression du capteur de pression, on détermine la valeur de la pression critique correspondant au signal de mesure critique.

5. Procédé selon la revendication 4, **caractérisé en ce qu'**on détermine la valeur de la pression critique correspondant au signal de mesure critique à l'aide de la courbe caractéristique course/pression connue du capteur de pression de référence, par extrapolation de cette courbe jusqu'à la valeur du signal de mesure critique.

6. Procédé selon l'une des revendications 1 à 5, **caractérisé en ce qu'**on vérifie le comportement statique du capteur de pression.

7. Utilisation d'une tige de commande de déviation (32) qu'on peut déplacer en course commandée (32) pour vérifier la fonctionnalité d'un élément de mesure (18) d'un capteur de pression qui peut se déformer de façon réversible, en particulier fléchir de façon réversible, exécutée par déformation de l'élément de mesure (18) au moyen de la tige de commande de déviation (32) qu'on peut déplacer de façon croissante, jusqu'à ce que l'élément de mesure (18) se brise, la force avec laquelle la tige de commande de déviation (32) agit sur l'élément de mesure (18) et/ou la pression correspondant à cette force qui agit sur l'élément de mesure (18) étant déterminée(s) au moyen de signaux de mesure émis par l'élément de mesure (18) au cours de la déformation croissante.

8. Utilisation selon la revendication 7 pour vérifier le comportement statique du capteur de pression.
